# EUROPEAN PATENT APPLICATION

(11) **EP 4 401 538 A1**
(43) Date of publication of application: **17.07.2024**
(21) Application number: 22867424.8
(22) Date of filing: 09.09.2022
(51) Int. Cl.: H10N 15/00, H02N 3/00

(54) **POWER GENERATION ELEMENT, METHOD FOR MANUFACTURING POWER GENERATION ELEMENT, POWER GENERATION DEVICE, AND ELECTRONIC APPARATUS**

(30) Priority: 10.09.2021 JP 2021147809; 24.12.2021 JP 2021211370
(71) Applicant: Illuminus Inc., Tokyo, 104-0061 (JP)
(72) Inventor: GOTO, Hiroshi, Tokyo 104-0061 (JP); SAKATA, Minoru, Tokyo 104-0061 (JP); YASUDA, Takuo, Tokyo 104-0061 (JP); ANDERSSON, LARS MATTIAS, Tokyo 104-0061 (JP); OKADA, Seiji, Tokyo 104-0061 (JP); NAKAMURA, Takahiro, Tokyo 104-0061 (JP)
(74) Representative: Novagraaf International SA
(86) International application number: PCT/JP2022/033831
(87) International publication number: WO 2023/038103

(57) **Abstract**

[Object]

To provide a power generation element, a method for manufacturing the power generation element, a power generation device, and an electronic apparatus that are capable of improving a power generation amount.

[Solution]

A power generation element 1 that does not require a temperature difference between electrodes in converting thermal energy into electric energy includes a first electrode 11, an intermediate portion 14 provided on the first electrode 11, the intermediate portion 14 including a fine particle exhibiting a perovskite structure, and a second electrode 12 provided on the intermediate portion 14, the second electrode 12 having a work function different from a work function of the first electrode 11. The fine particle includes, for example, at least one of titanium and zirconium.

## Description

### Technical Field

The present invention relates to a method for manufacturing a power generation element that does not require a temperature difference between electrodes in converting thermal energy into electric energy, a power generation element, a power generation device, and an electronic apparatus.

### Background Art

In recent years, power generation elements that generate electric energy by utilizing thermal energy have been actively developed. In particular, regarding a power generation element that does not require a temperature difference between electrodes, for example, a power generation element disclosed in Patent Literature 1 or the like has been proposed. Such a power generation element is expected to be used in various applications as compared with a configuration in which electric energy is generated by using a temperature difference applied between electrodes.

Patent Literature 1 discloses a method for manufacturing a power generation element including a generating process of generating nanoparticles dispersed in a solvent or an organic solvent by using a femtosecond pulse laser, a first electrode portion forming process of forming a first electrode portion on a first substrate, a second electrode portion forming process of forming a second electrode portion on a second substrate, and a bonding process of bonding the first substrate and the second substrate with the solvent or the organic solvent interposed between the first electrode portion and the second electrode portion.

### Citation List

### Patent Literature

Patent Literature 1: JP 6781437 B

### Summary of Invention

### Technical Problem

Here, for the power generation element as disclosed in Patent Literature 1, a difference in work function between electrodes is mainly given as a parameter that affects a power generation amount. Thus, when the selection of materials to be used for the electrodes is limited, it is difficult to improve the power generation amount.

The present invention has been made in consideration of the above problem, and an object of the present invention is to provide a power generation element, a method for manufacturing the power generation element, a power generation device, and an electronic apparatus that are capable of improving a power generation amount.

### Solution to Problem

A power generation element according to a first aspect of the present invention is a power generation element that does not require a temperature difference between electrodes in converting thermal energy into electric energy, the power generation element including a first electrode, an intermediate portion provided on the first electrode, the intermediate portion including a fine particle exhibiting a perovskite structure, and a second electrode provided on the intermediate portion, the second electrode having a work function different from a work function of the first electrode.

A power generation element according to a second aspect of the present invention is the power generation element according to the first aspect of the present invention, wherein the fine particle includes at least one of titanium and zirconium.

A power generation element according to a third aspect of the present invention is the power generation element according to the first aspect or the second aspect of the present invention, wherein the fine particle includes at least one of barium titanate, strontium titanate, calcium titanate, lead titanate, tin titanate, cadmium titanate, and strontium zirconate.

A power generation element according to a fourth aspect of the present invention is the power generation element according to any one of the first aspect to the third aspect of the present invention, wherein the intermediate portion includes a non-conductive layer including the fine particle, the non-conductive layer supporting the first electrode and the second electrode.

A power generation element according to a fifth aspect of the present invention is the power generation element according to the fourth aspect of the present invention, wherein the non-conductive layer includes a material having hydrophilicity.

A power generation element according to a sixth aspect of the present invention is the power generation element according to the fifth aspect of the present invention, wherein the non-conductive layer includes an organic polymer compound.

A power generation element according to a seventh aspect of the present invention is the power generation element according to any one of the fourth aspect to the sixth aspect of the present invention, wherein the intermediate portion includes a plurality of locking portions supporting the first electrode and the second electrode.

A power generating element according to an eighth aspect of the present invention is the power generation element according to the seventh aspect of the present invention, wherein each of the plurality of locking portions has a spherical shape having a median diameter larger than a median diameter of the fine particle.

A method for manufacturing a power generation element according to a ninth aspect of the present invention is a method for manufacturing a power generation element that does not require a temperature difference between electrodes in converting thermal energy into electric energy, the method including an element forming process of forming a first electrode, an intermediate portion including a fine particle exhibiting a perovskite structure, and a second electrode having a work function different from a work function of the first electrode.

A power generation device according to a tenth aspect of the present invention is a power generation device including the power generation element according to the first aspect of the present invention, a first wiring line electrically connected to the first electrode, and a second wiring line electrically connected to the second electrode.

An electronic apparatus according to an eleventh aspect of the present invention is an electronic apparatus including the power generation element according to the first aspect of the present invention, and an electronic component configured to be driven by using the power generation element as a power source.

### Advantageous Effects of Invention

According to the first aspect to the ninth aspect of the present invention, the intermediate portion includes the fine particle having the perovskite structure. Thus, protons generated from water molecules contained in the atmosphere or the like around the power generation element move to the electrode on a low potential side due to an electric field between the electrodes. Then, along with the movement of protons, movement of electrons between the electrodes is activated. This makes it possible to improve a power generation amount.

In particular, according to the fourth aspect of the present invention, the intermediate portion includes the non-conductive layer including the fine particle. That is, the movement of fine particles between the electrodes is suppressed by the non-conductive layer. For this reason, uneven distribution of the fine particles on one electrode side over time and a decrease in movement amount of electrons can be suppressed. This makes it possible to stabilize the power generation amount.

In particular, according to the fourth aspect of the present invention, the intermediate portion includes the non-conductive layer supporting the first electrode and the second electrode. Thus, as compared with a case where a solvent or the like is used instead of the non-conductive layer, a support portion or the like for maintaining a distance (gap) between the electrodes does not need to be provided, and a variation in the gap caused by formation accuracy of the support portion can be eliminated. This makes it possible to increase the power generation amount.

In particular, according to the fifth aspect of the present invention, the non-conductive layer includes the material having hydrophilicity. Thus, a state in which water molecules are close to the fine particles can be easily maintained. This makes it possible to further stabilize the power generation amount.

In particular, according to the sixth aspect of the present invention, the non-conductive layer includes the organic polymer compound. Thus, the non-conductive layer can be flexibly formed. This makes it possible to obtain the power generation element having a shape suitable for its application.

In particular, according to the seventh aspect of the present invention, the intermediate portion includes the plurality of locking portions that support the first electrode and the second electrode. For this reason, a variation in the gap caused by the non-conductive layer can be suppressed. This makes it possible to further increase the power generation amount.

In particular, according to the eighth aspect of the present invention, each of the locking portions has the spherical shape having the median diameter larger than the median diameter of the fine particle. Thus, a contact area between the locking portion and each electrode can be minimized. This makes it possible to suppress a decrease in the power generation amount along with the arrangement of the locking portions.

In particular, according to the tenth aspect of the present invention, the power generation device includes the power generation element according to the first aspect of the present invention. This makes it possible to implement the power generation device that stabilizes the power generation amount.

In particular, according to the eleventh aspect of the present invention, the electronic apparatus includes the power generation element according to the first aspect of the present invention. This makes it is possible to implement the electronic apparatus that stabilizes the power generation amount.

### Brief Description of Drawings

FIG. 1(a) is a schematic cross-sectional view illustrating an example of a power generation element and a power generation device according to a first embodiment, and FIG. 1(b) is a schematic cross-sectional view taken along a line A-A in FIG. 1(a).
FIG. 2 is a schematic cross-sectional view illustrating an example of an intermediate portion.
FIG. 3 is a flowchart illustrating an example of a method for manufacturing the power generation element according to the first embodiment.
FIG. 4(a) to FIG. 4(d) are schematic cross-sectional views illustrating an example of the method for manufacturing the power generation element according to the first embodiment.
FIG. 5(a) is a schematic cross-sectional view illustrating a first modification of the power generation element and the power generation device according to the first embodiment, and FIG. 5(b) is a schematic cross-sectional view illustrating a second modification of the power generation element and the power generation device according to the first embodiment.
FIG. 6 is a schematic cross-sectional view illustrating a first modification of the intermediate portion.
FIG. 7 is a schematic cross-sectional view illustrating a second modification of the intermediate portion.
FIG. 8 is a schematic cross-sectional view illustrating an example of an intermediate portion of a power generation element according to a second embodiment.
FIG. 9(a) to FIG. 9(d) are schematic block diagrams illustrating an example of an electronic apparatus including the power generation element, and FIG. 9(e) to FIG. 9(h) are schematic block diagrams illustrating an example of an electronic apparatus including the power generation device including the power generation element.
FIG. 10 is a schematic view illustrating an operation example of the power generation element according to the first embodiment.

### Description of Embodiments

Hereinafter, examples of a method for manufacturing a power generation element, a power generation element, a power generation device, and an electronic apparatus as embodiments of the present invention will be described with reference to the drawings. Note that in each drawing, a height direction in which electrodes are laminated is referred to as a first direction Z, one planar direction intersecting, for example, orthogonal to, the first direction Z is referred to as a second direction X, and another planar direction intersecting, for example, orthogonal to, both of the first direction Z and the second direction X is referred to as a third direction Y. In addition, a configuration in each drawing is schematically illustrated for description, and for example, a size of each configuration, a ratio of sizes between configurations, or the like may be different from that in the drawing.

### First Embodiment: Power Generation Element 1, Power Generation Device 100

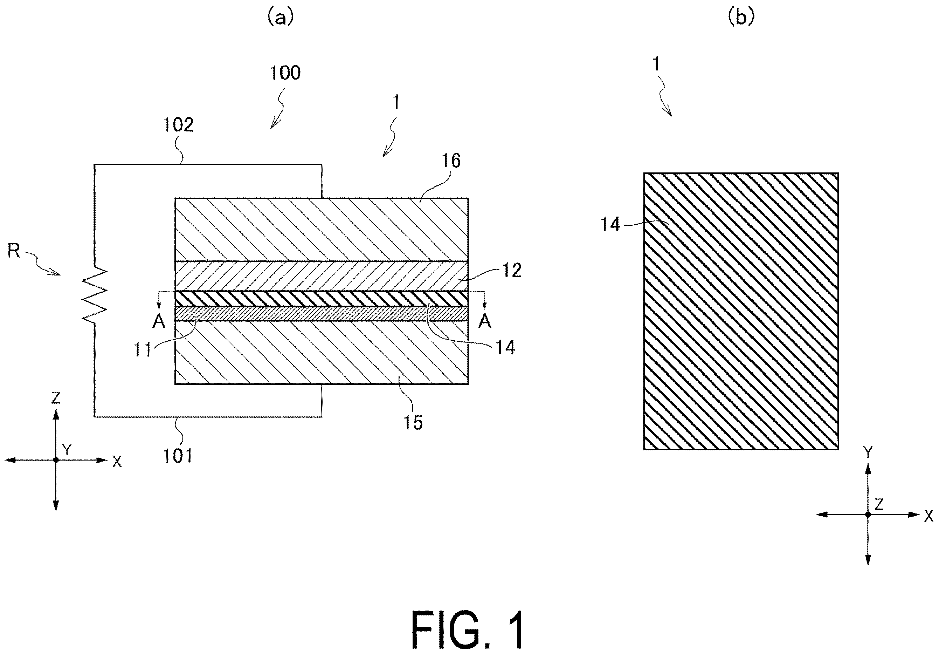

FIG. 1 is a schematic view illustrating an example of a power generation element 1 and a power generation device 100 according to the present embodiment. FIG. 1(a) is a schematic cross-sectional view illustrating an example of the power generation element 1 and the power generation device 100 according to the present embodiment, and FIG. 1(b) is a schematic cross-sectional view taken along a line A-A in FIG. 1(a).

### Power Generation Device 100

As illustrated in FIG. 1(a), the power generation device 100 includes the power generation element 1, a first wiring line 101, and a second wiring line 102. The power generation element 1 converts thermal energy into electric energy. The power generation device 100 including such a power generation element 1 is mounted or installed at a heat source (not illustrated), for example, and outputs electric energy generated from the power generation element 1 to a load R through the first wiring line 101 and the second wiring line 102 based on thermal energy of the heat source. One end of the load R is electrically connected to the first wiring line 101, and the other end is electrically connected to the second wiring line 102. The load R is, for example, an electrical device. The load R is driven by using, for example, the power generation device 100 as a main power source or an auxiliary power source.

Examples of a heat source of the power generation element 1 include an electronic device or an electronic component such as a central processing unit (CPU), a light emitting element such as a light emitting diode (LED), an engine of an automobile or the like, production equipment of a factory, a human body, sunlight, and an environmental temperature. For example, the electronic device, electronic component, light emitting element, engine, and production equipment, and the like are artificial heat sources. The human body, sunlight, and environmental temperature, and the like are natural heat sources. The power generation device 100 including the power generation element 1 can be provided inside a mobile device such as an Internet of Things (IoT) device and a wearable device or an autonomous sensor terminal, and can be used as an alternative or an auxiliary of a battery. Further, the power generation device 100 can be applied to a larger power generation device for photovoltaic power generation or the like.

### Power Generation Element 1

The power generation element 1 converts, for example, thermal energy generated by the artificial heat source or thermal energy of the natural heat source into electric energy to generate an electric current. Not only can the power generation element 1 be provided in the power generation device 100 but also the power generation element 1 itself can be provided in the mobile device, the autonomous sensor terminal, or the like. In this case, the power generation element 1 itself can serve as an alternative component or an auxiliary component of the battery for the mobile device, the autonomous sensor terminal, or the like.

For example, as illustrated in FIG. 1(a), the power generation element 1 includes a first electrode 11, a second electrode 12, and an intermediate portion 14. The power generation element 1 may include, for example, at least one of a first substrate 15 and a second substrate 16.

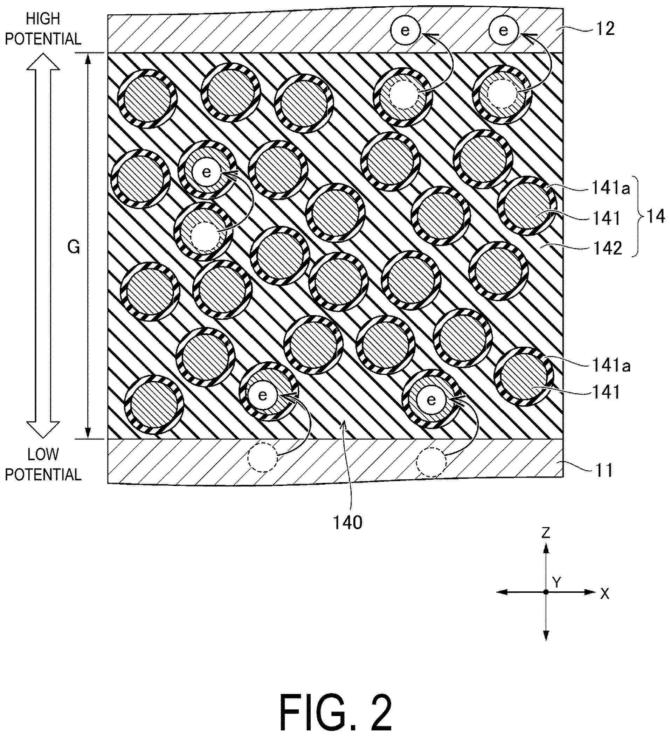

The first electrode 11 and the second electrode 12 are provided so as to face each other. The first electrode 11 and the second electrode 12 have different work functions from each other. For example, as illustrated in FIG. 2, the intermediate portion 14 is provided in a space 140 including a gap (gap G) between the first electrode 11 and the second electrode 12.

For example, the work function of the first electrode 11 is larger than the work function of the second electrode 12. In this case, an electric field is generated in the gap G, the first electrode 11 has a low potential, and the second electrode 12 has a high potential.

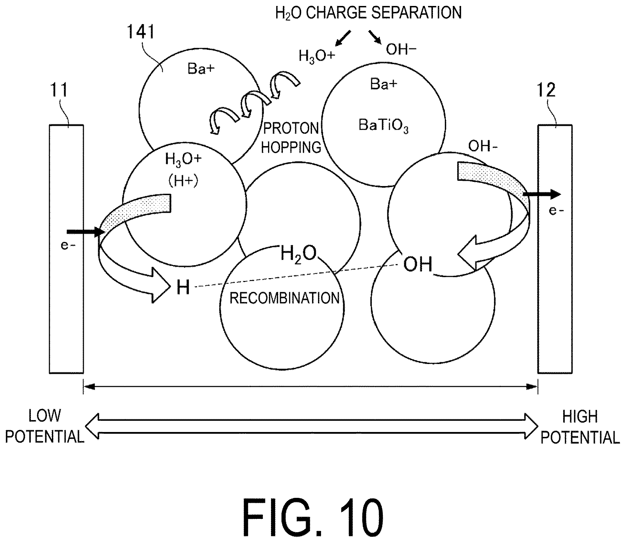

The intermediate portion 14 includes fine particles 141 exhibiting a perovskite structure. Here, for example, as illustrated in FIG. 10, water molecules contained in the atmosphere around the power generation element 1 can react with metal ions such as barium contained in the perovskite structure. Thus, hydronium (H₃O⁺) and hydroxide ion (OH⁻) are generated from the water molecules. Hydronium transmits a proton (H⁺) to an adjacent water molecule. At this time, it is assumed that a transfer rate of protons tends to be extremely higher than that of ionic conduction or the like. Here, due to the electric field in the gap G generated based on the difference in work function between the electrodes 11 and 12, the protons move toward the electrode on the low potential side (the first electrode 11 in FIG. 10) and the hydroxide ions move toward the electrode on the high potential side (the second electrode 12 in FIG. 10). Thereafter, the protons receive electrons from the first electrode 11 on the low potential side, and the hydroxide ions supply electrons to the second electrode 12 on the high potential side. Accordingly, the movement of electrons between the electrodes 11 and 12 is activated. This makes it possible to improve a power generation amount.

Hereinafter, each configuration will be described in detail.

### First Electrode 11 and Second Electrode 12

For example, as illustrated in FIG. 1(a), the first electrode 11 and the second electrode 12 are separated from each other in the first direction Z. Each of the electrodes 11 and 12 extends in, for example, the second direction X and the third direction Y, and a plurality of electrodes 11 and/or 12 may be provided. For example, one second electrode 12 may be provided so as to face a plurality of first electrodes 11 at different positions. In addition, for example, one first electrode 11 may be provided to face a plurality of second electrodes 12 at different positions.

As a material of each of the first electrode 11 and the second electrode 12, a material having electrical conductivity is used. For example, materials having different work functions from each other are used as the materials of the first electrode 11 and the second electrode 12. Note that the same material may be used for the electrodes 11 and 12, and in this case, it is sufficient that the electrodes 11 and 12 have different work functions from each other.

As the material of each of the electrodes 11 and 12, for example, a material made of a single element such as iron, aluminum, or copper may be used, or for example, an alloy material made of two types or more of elements may be used. For example, a non-metal conductive material may be used as the material of each of the electrodes 11 and 12. Examples of the non-metal conductive material include silicon (Si: for example, p-type Si or n-type Si) and a carbon-based material such as graphene.

Thicknesses of the first electrode 11 and the second electrode 12 in the first direction Z are equal to or more than 4 nm and equal to or less than 1 µm, for example. The thicknesses of the first electrode 11 and the second electrode 12 in the first direction Z may be, for example, equal to or more than 4 nm and equal to or less than 50 nm.

The gap G indicating the distance between the first electrode 11 and the second electrode 12 can be set in a freely selected manner, by changing a thickness of a non-conductive layer 142, for example. For example, narrowing the gap G can cause the electric field generated between the electrodes 11 and 12 to be enlarged, and thus the power generation amount of the power generation element 1 can be increased. In addition, for example, narrowing the gap G can cause a thickness of the power generation element 1 in the first direction Z to be reduced.

The gap G is, for example, a finite value equal to or less than 500 µm. The gap G is, for example, equal to or more than 10 nm and equal to or less than 1 µm. For example, when the gap G is equal to or smaller than 200 nm, a variation in the gap G of a surface along the second direction X and the third direction Y may lead to a decrease in the power generation amount. Additionally, when the gap G is larger than 1 µm, the electric field generated between the electrodes 11 and 12 may be weakened. Thus, the gap G is preferably larger than 200 nm and equal to or smaller than 1 µm.

### Intermediate Portion 14

The intermediate portion 14 includes, for example, the fine particles 141 and the non-conductive layer 142. The non-conductive layer 142 contains the fine particles 141 and supports the first electrode 11 and the second electrode 12. In this case, movement of the fine particles 141 in the gap G is suppressed by the non-conductive layer 142. For this reason, uneven distribution of the fine particles 141 to one of the electrodes 11 and 12 over time and a decrease in movement amount of electrons can be prevented. This makes it possible to stabilize the power generation amount.

The non-conductive layer 142 is formed by curing a non-conductive material, for example. The non-conductive layer 142 is, for example, solid. The non-conductive layer 142 may include, for example, a residue of a diluent or an uncured portion of the non-conductive material. Also in this case, the power generation amount can be stabilized in a manner similar to that described above. Further, the fine particles 141 are fixed, for example, in a dispersed state in the non-conductive layer 142. Also in this case, the power generation amount can be stabilized in a manner similar to that described above.

The intermediate portion 14 is provided on the first electrode 11. Moreover, the second electrode 12 is provided on the non-conductive layer 142. Here, in the power generation element 1 that does not require the temperature difference between the electrodes in converting thermal energy into electric energy, suppressing a variation in the gap G in a surface along the second direction X and the third direction Y can cause the power generation amount to be increased. In this regard, when a liquid such as a solvent is used as the intermediate portion, a support portion or the like for maintaining the gap G needs to be provided. However, there has been a concern that the variation in the gap G may be increased due to the formation of the support portion or the like. In contrast, in the power generation element 1 according to the present embodiment, since the second electrode 12 is provided on the non-conductive layer 142, the support portion or the like for maintaining the gap G does not need to be provided, and the variation in the gap caused by formation accuracy of the support portion or the like can be eliminated. This makes it possible to increase the power generation amount.

In addition, when the support portion or the like for maintaining the gap is provided, there is a concern that the fine particles 141 come into contact with the support portion and aggregate around the support portion. On the other hand, in the power generation element 1 according to the present embodiment, the state in which the fine particles 141 aggregate due to the support portion can be eliminated. This makes it possible to maintain the stable power generation amount.

For example, as illustrated in FIG. 1(b), the intermediate portion 14 extends in a plane along the second direction X and the third direction Y. The intermediate portion 14 is provided in the space 140 formed between the electrodes 11 and 12. The intermediate portion 14 may be in contact with main surfaces of the electrodes 11 and 12 that face each other, or may be in contact with side surfaces of the electrodes 11 and 12, for example.

The fine particles 141 are dispersed in the non-conductive layer 142, and for example, some of the fine particles 141 may be exposed from the non-conductive layer 142. For example, the fine particles 141 may be filled in the gap G, and the non-conductive layer 142 may be provided in a gap between the fine particles 141. A particle diameter of the fine particle 141 is smaller than the gap G, for example. The particle diameter of the fine particle 141 is set to a finite value equal to or less than 1/10 of the gap G, for example. When the particle diameter of the fine particle 141 is set to be equal to or less than 1/10 of the gap G, the intermediate portion 14 including the fine particle 141 is easily formed in the space 140. As a result, workability can be improved when the power generation element 1 is produced.

Here, the "fine particle" includes a plurality of particles. The fine particle 141 includes particles each of which has a particle diameter equal to or more than 2 nm and equal to or less than 1000 nm, for example. The fine particle 141 may include, for example, particles having particle diameters whose median diameter (D50) is equal to or more than 3 nm and equal to or less than 8 nm, or particles having particle diameters whose average particle diameter is equal to or more than 3 nm and equal to or less than 8 nm. The median diameter or the average particle diameter can be measured by using, for example, a particle size distribution measuring instrument. As the particle size distribution measuring instrument, for example, a particle size distribution measuring instrument using a dynamic light scattering method (for example, Zetasizer Ultra manufactured by Malvern Panalytical Ltd. or the like) may be used.

The fine particle 141 has a perovskite structure. The fine particle 141 contains, for example, at least one of titanium and zirconium.

The fine particle 141 contains, for example, at least one of barium titanate (BaTiO₃), strontium titanate (SrTiO₃), calcium titanate (CaTiO₃), lead titanate (PbTiO₃), tin titanate (SnTiO₃), cadmium titanate (CdTiO₃), and strontium zirconate (SrZrO₃).

The fine particle 141 includes, for example, a coating 141a on the surface thereof. The coating 141a has a thickness of, for example, a finite value equal to or less than 20 nm. Providing such a coating 141a on the surface of each fine particle 141 allows aggregation of the fine particles 141 when the fine particles 141 are dispersed in the non-conductive layer 142 to be suppressed. In addition, for example, it is possible to increase a probability that electrons will move between the first electrode 11 and the fine particle 141, between the plurality of fine particles 141, and between the second electrode 12 and the fine particle 141, by using the tunneling effect or the like.

As the coating 141a, for example, a material including a thiol group or a disulfide group is used. As the material including the thiol group, for example, alkanethiol such as dodecanethiol is used. As the material including the disulfide group, for example, alkane disulfide or the like is used.

The non-conductive layer 142 is provided between the electrodes 11 and 12, and is in contact with the respective electrodes 11 and 12, for example. The non-conductive layer 142 has a thickness of a finite value equal to or less than 500 µm, for example. The thickness of the non-conductive layer 142 affects the value and variation of the gap G described above. Thus, for example, when the thickness of the non-conductive layer 142 is equal to or less than 200 nm, the variation in the gap G in the surface along the second direction X and the third direction Y may lead to a decrease in the power generation amount. In addition, when the thickness of the non-conductive layer 142 is larger than 1 µm, the electric field generated between the electrodes 11 and 12 may be weakened. For these reasons, the thickness of the non-conductive layer 142 is preferably equal to or more than 200 nm and equal to or less than 1 µm.

The non-conductive layer 142 may include, for example, one type of material, or may include a plurality of materials depending on the application. As the non-conductive layer 142, for example, a material described in ISO1043-1 or JIS K 6899-1 may be used. The non-conductive layer 142 may include, for example, a plurality of layers containing different materials, and may include a configuration in which the layers are laminated. When the non-conductive layer 142 includes a plurality of layers, for example, the layers may contain (for example, be dispersed with) the fine particles 141 including different materials from each other.

The non-conductive layer 142 has, for example, an insulating property. The material to be used for the non-conductive layer 142 is freely selected as long as the material is a non-conductive material capable of fixing the fine particles 141 in a dispersed state, but an organic polymer compound is preferably used. When the non-conductive layer 142 includes the organic polymer compound, the non-conductive layer 142 can be formed so as to be flexible, and thus the power generation element 1 having a shape such as a curved shape or a bent shape according to the application can be formed.

As the organic polymer compound, polyimide, polyamide, polyester, polycarbonate, poly (meth) acrylate, a radical polymerization system of photosetting resin or thermosetting resin, a photocationic polymerization system of photosetting resin or thermosetting resin, an epoxy resin, a copolymer containing an acrylonitrile component, polyvinylphenol, polystyrene, a novolac resin, polyvinylidene fluoride, or the like can be used.

The non-conductive layer 142 includes, for example, a material having hydrophilicity. In this case, the state in which the water molecules are close to the fine particles 141 can be easily maintained. As the non-conductive layer 142, for example, a material such as polyvinyl alcohol, methyl cellulose, or polyethylene glycol is used. Examples of the material having hydrophilicity include known materials such as nonionic polymers, anionic polymers, cationic polymers, acrylic resins, polyester resins, and polyurethane resins.

Note that, for example, an inorganic substance may be used as the non-conductive layer 142. Examples of the inorganic substance include porous inorganic substances such as zeolite and diatomaceous earth, and cage-like molecules.

### First Substrate 15 and Second Substrate 16

For example, as illustrated in FIG. 1(a), the first substrate 15 and the second substrate 16 are provided to sandwich the electrodes 11 and 12 and the intermediate portion 14 and to be separated from each other in the first direction Z. For example, the first substrate 15 is in contact with the first electrode 11 and is separated from the second electrode 12. The first substrate 15 fixes the first electrode 11. The second substrate 16 is in contact with the second electrode 12 and is separated from the first electrode 11. The second substrate 16 fixes the second electrode 12.

Thicknesses of the substrates 15 and 16 in the first direction Z are, for example, equal to or more than 10 µm and equal to or less than 2 mm. The thicknesses of the substrates 15 and 16 can be freely selected and set. A shape of each of the substrates 15 and 16 may be, for example, a quadrangular shape such as a square or a rectangle, a disk shape, or the like, and can be freely selected and set according to the application.

As each of the substrates 15 and 16, for example, a plate-shaped member having an insulating property can be used, and for example, a known member made of a material such as silicon, quartz, or Pyrex (registered trademark) can be used. For each of the substrates 15 and 16, for example, a film-like member may be used, and for example, a known film-like member made of a material such as polyethylene terephthalate (PET), polycarbonate (PC), or polyimide may be used.

As each of the substrates 15 and 16, for example, a member having electrical conductivity can be used, and examples thereof include iron, aluminum, copper, and an alloy of aluminum and copper. In addition, as the substrates 15 and 16, a member made of a material such as an electrically conductive semiconductor such as Si or GaN, or a conductive polymer may be used. When the member having the electrical conductivity is used for each of the substrates 15 and 16, wiring lines for connection to the electrodes 11 and 12 are not required.

For example, when the first substrate 15 is a semiconductor, the first substrate 15 may include a degenerate portion being in contact with the first electrode 11. In this case, a contact resistance between the first electrode 11 and the first substrate 15 can be reduced, compared to a case where the degenerate portion is not provided. The first substrate 15 may include the degenerate portion on a surface different from the surface being in contact with the first electrode 11. In this case, the contact resistance with a wiring line (for example, the first wiring line 101) electrically connected to the first substrate 15 can be reduced.

For example, when a plurality of power generation elements 1 illustrated in FIG. 1(a) are laminated, a semiconductor may be used as the first substrate 15 and the second substrate 16. In this case, the contact resistance can be reduced by providing the degenerate portion on the contact surface between the substrates 15 and 16 that come into contact with each other along with laminating the power generation elements 1.

The above-described degenerate portion is formed, for example, by ion-implanting an n-type dopant into the semiconductor at a high concentration or by coating the semiconductor with a material such as glass containing an n-type dopant and performing heat treatment after the coating.

Note that examples of an impurity to be doped into the first substrate 15 made of the semiconductor include known impurities such as P, As, and Sb in the case of n-type impurities, and known impurities such as B, Ba, and Al in the case of p-type impurities. Additionally, when the concentration of the impurity in the degenerate portion is, for example, 1 × 10¹⁹ ions/cm³, electrons can be efficiently emitted.

For example, when the first substrate 15 is a semiconductor, a specific resistance value of the first substrate 15 may be, for example, equal to or more than 1 × 10⁻⁶ Ω·cm and equal to or less than 1 × 10⁶ Ω·cm. When the specific resistance value of the first substrate 15 is less than 1 × 10⁻⁶ Ω·cm, selection of the material is difficult. In addition, when the specific resistance value of the first substrate 15 is larger than 1 × 10⁶ Ω·cm, there is a concern that an electric current loss increases.

It should be noted that although the case where the first substrate 15 is the semiconductor has been described above, the second substrate 16 may be a semiconductor. Since this case is similar to the case described above, description will be omitted.

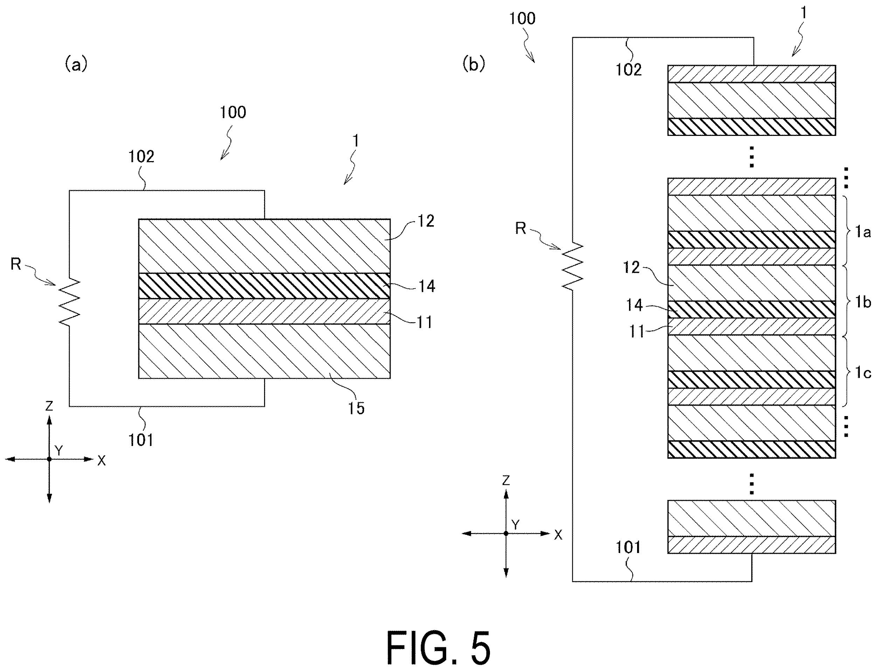

Note that the power generation element 1 may include only the first substrate 15 as illustrated in FIG. 5(a), for example, or may include only the second substrate 16. Additionally, for example, as illustrated in FIG. 5(b), the power generation element 1 may have a laminated structure of a plurality of structures (for example, 1a, 1b, 1c, and the like) each of which is obtained by laminating the first electrode 11, the intermediate portion 14, and the second electrode 12 in this order without including the substrates 15 and 16, or may have a laminated structure including at least one of the substrates 15 and 16.

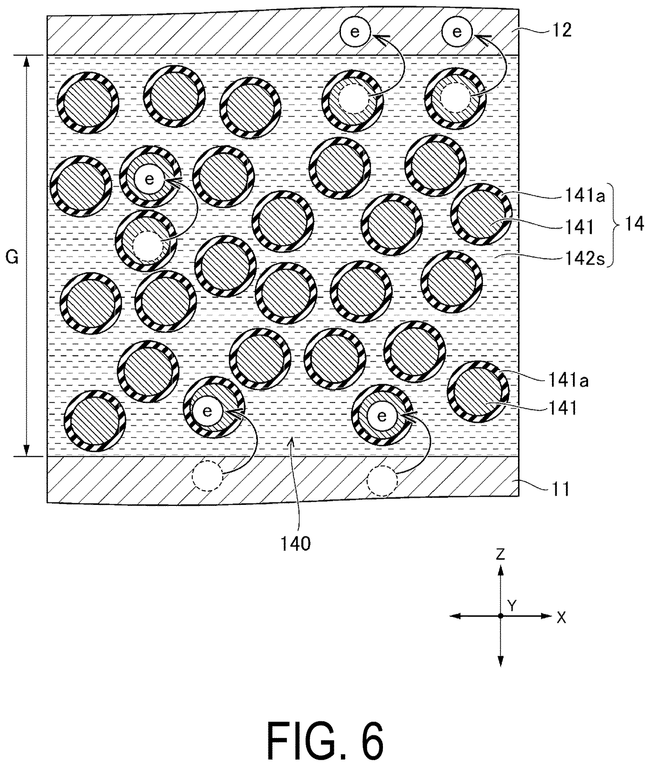

Note that, for example, as illustrated in FIG. 6, the intermediate portion 14 may include a solvent 142s instead of the non-conductive layer 142. In this case, the fine particles 141 are dispersed in the solvent 142s. Further, each of the electrodes 11 and 12 is supported by a support portion (not illustrated). As the solvent 142s, known liquids such as, for example, water and toluene are used. Also in this case, including the fine particles 141 having the perovskite structure described above causes the power generation amount to be improved.

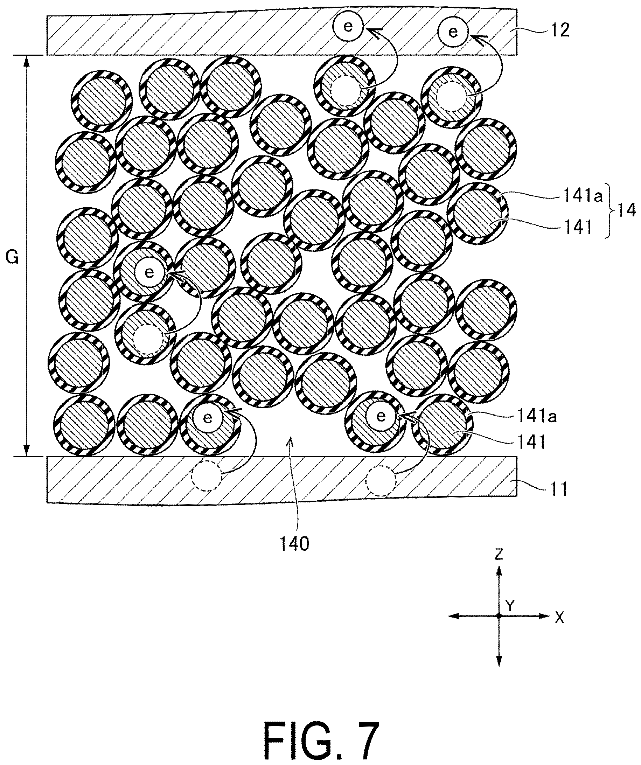

Note that for example, as illustrated in FIG. 7, the intermediate portion 14 does not need to include the non-conductive layer 142. In this case, the fine particles 141 are filled in the gap G. Further, each of the electrodes 11 and 12 is supported by the support portion (not illustrated). Also in this case, including the fine particles 141 having the perovskite structure described above causes the power generation amount to be improved.

### Operation Example of Power Generation Element 1

For example, when thermal energy is applied to the power generation element 1, an electric current is generated between the first electrode 11 and the second electrode 12, and the thermal energy is converted into electric energy. An amount of the electric current generated between the first electrode 11 and the second electrode 12 depends not only on the thermal energy but also on the difference between the work function of the second electrode 12 and the work function of the first electrode 11.

The amount of the generated electric current can be increased by, for example, increasing the difference between the work functions of the first electrode 11 and the second electrode 12 and decreasing the gap G. For example, an amount of the electric energy generated by the power generation element 1 can be increased by considering at least one of increasing the difference between the work functions and decreasing the gap G. In addition, providing the fine particles 141 between the electrodes 11 and 12 can increase the amount of electrons moving between the electrodes 11 and 12, which can lead to an increase in the amount of the electric current.

In addition to the above, the power generation element 1 according to the present embodiment includes the fine particles 141 exhibiting the perovskite structure. Thus, this activates the movement of electrons between the electrodes 11 and 12 due to the characteristics of the protons described above. This makes it possible to improve the power generation amount.

Note that the "work function" refers to the minimum energy required to extract, into a vacuum, electrons existing in a solid. The work function can be measured by using ultraviolet photoelectron spectroscopy (UPS), X-ray photoelectron spectroscopy (XPS), or Auger electron spectroscopy (AES), for example. Note that as the "work function", an actual measurement value targeted for each configuration of the power generation element 1 may be used, or for example, a known value measured for a material may be used.

### Embodiment: Method for Manufacturing Power Generation Element 1

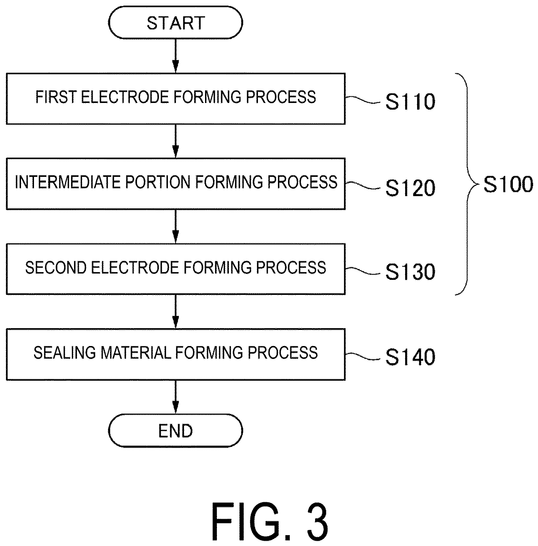

Next, an example of a method for manufacturing the power generation element 1 according to the present embodiment will be described. FIG. 3 is a flowchart illustrating the example of the method for manufacturing the power generation element 1 according to the present embodiment.

The method for manufacturing the power generation element 1 includes an element forming process S100, and may include, for example, a sealing material forming process S140.

### Element Forming Process S100

In the element forming process S100, the first electrode 11, the intermediate portion 14, and the second electrode 12 are formed. In the element forming process S100, for example, a plurality of structures each of which includes the first electrode 11, the intermediate portion 14, and the second electrode 12 may be laminated. In the element forming process S100, the first electrode 11, the intermediate portion 14, and the second electrode 12 are formed by using, for example, a known forming technique. The element forming process S100 includes, for example, a first electrode forming process S 110, an intermediate portion forming process S120, and a second electrode forming process S130. Note that the steps S 110, S120, and S130 may be performed in any order.

### First Electrode Forming Process S 110

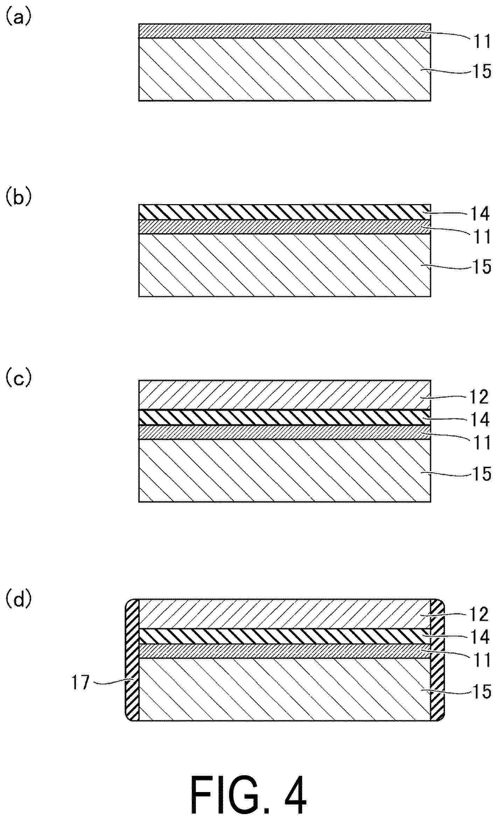

In the first electrode forming process S 110, the first electrode 11 is formed. In the first electrode forming process S110, for example, as illustrated in FIG. 4(a), the first electrode 11 is formed on the first substrate 15. The first electrode 11 is formed by, for example, a sputtering method or a vacuum deposition method under a reduced pressure environment, for example, or is formed by using a known electrode forming technique. Note that in the first electrode forming process S110, for example, the first electrode 11 may be formed by processing an extended electrode material into a freely selected size instead of the first substrate 15. In this case, the first substrate 15 does not need to be used.

In the first electrode forming process S110, the first electrode 11 may be formed on the first substrate 15, for example. For example, when a film-like member is used as the first substrate 15, the first electrode 11 may be applied onto the first substrate 15, and the first substrate 15 and the first electrode 11 may be wound into a roll shape. Thereafter, for example, in at least one of the intermediate portion forming process S120, the second electrode forming process S130, and the sealing material forming process S140, which will be described later, the first substrate 15 and the first electrode 11 may be cut into an area corresponding to the application.

### Intermediate Portion Forming Process S120

In the intermediate portion forming process S120, for example, as illustrated in FIG. 4(b), the intermediate portion 14 including the non-conductive layer 142 is formed on the first electrode 11. In the intermediate portion forming process S120, for example, a non-conductive material containing the fine particles 141 is applied to the surface of the first electrode 11 and the like, and the non-conductive material is cured to form the non-conductive layer 142. Thus, the intermediate portion 14 including the non-conductive layer 142 containing the fine particles 141 is formed.

In the intermediate portion forming process S120, the non-conductive material is applied to the surface of the first electrode 11 by a known coating technique such as a screen printing method or a spin coating method. A film thickness of the non-conductive material to be applied can be freely selected and set in accordance with design of the gap G described above.

As the non-conductive material, a known polymer material having an insulating property such as an epoxy resin is used. As the non-conductive material, in addition to a thermosetting resin, for example, an ultraviolet curable resin is used. In the intermediate portion forming process S120, heating, UV irradiation, or the like may be performed on the applied non-conductive material depending on the characteristics of the non-conductive material to form the non-conductive layer 142.

In the intermediate portion forming process S120, for example, a fine particle material may be mixed into a freely selected inorganic material, and then, laser irradiation may be performed. Accordingly, the non-conductive layer 142 containing the fine particles 141 is formed, and the intermediate portion 14 is formed.

### Second Electrode Forming Process S130

In the second electrode forming process S130, for example, as illustrated in FIG. 4(c), the second electrode 12 is formed on the non-conductive layer 142. The second electrode 12 is formed by using, for example, a material having a work function lower than that of the first electrode 11. The second electrode 12 is formed by using a known electrode forming technique such as a nanoimprinting method.

In the second electrode forming process S130, the second electrode 12 is formed on the surface of the non-conductive layer 142 by a sputtering method or a vacuum deposition method under a reduced pressure environment, for example. In this case, when the second electrode 12 is formed, a main surface of the second electrode 12 is in contact with the non-conductive layer 142 without being exposed to the atmosphere or the like. This can suppress a variation in the work function of the second electrode 12. This makes it possible to further stabilize the power generation amount.

In the second electrode forming process S130, the second electrode 12 may be formed by bringing the surface of the second electrode 12 provided on the second substrate 16 in advance into contact with the surface of the non-conductive layer 142, for example. In this case, as compared with the case where the second electrode 12 is directly formed on the surface of the non-conductive layer 142, a variation in a surface state of the second electrode 12 caused by a surface state of the non-conductive layer 142 can be suppressed. This makes it possible to increase the power generation amount.

For example, when a film-like member is used as the second substrate 16, the suppression of the variation can be achieved by preparing the second substrate 16 coated with the second electrode 12, and for example, the second substrate 16 and the second electrode 12 may be prepared in a wound state into a roll shape. Thereafter, for example, before or after the sealing material forming process S140, which will be described later, the second substrate 16 and the second electrode 12 may be cut into an area according to the application.

Note that in the second electrode forming process S130, for example, the intermediate portion 14 and the second electrode 12 may be heated after forming the second electrode 12 on the non-conductive layer 142. The heating of the intermediate portion 14 and the second electrode 12 may be performed instead of the heating in the intermediate portion forming process S120, for example, or may be performed in addition to the heating in the intermediate portion forming process S120. In this case, the surface of the non-conductive layer 142 being in contact with the second electrode 12 is easily flattened. This can suppress the occurrence of a slight gap between the non-conductive layer 142 and the second electrode 12. This makes it possible to increase the power generation amount.

### Sealing Material Forming Process S140

For example, the sealing material forming process S140 may be performed after the second electrode forming process S130. In the sealing material forming process S140, for example, as illustrated in FIG. 4(d), the sealing material 17 is formed so as to be in contact with at least one of the first electrode 11, the intermediate portion 14, and the second electrode 12. The sealing material 17 is formed by using a known technique such as a nanoimprinting method.

As the sealing material 17, an insulating material is used, and for example, a known insulating resin such as fluorine-based insulating resins is used. Forming the sealing material 17 can suppress deterioration of the non-conductive layer 142 and the fine particles 141 due to an external environment. This can improve durability.

In particular, when the sealing material 17 is formed so as to cover the intermediate portion 14, the intermediate portion 14 is not exposed to the outside, which can further improve the durability.

The power generation element 1 according to the present embodiment is formed by performing the above-described processes. For example, the second substrate 16 illustrated in FIG. 1(a) may be formed on the second electrode 12. In addition, the power generation device 100 according to the present embodiment is formed by forming the wiring lines 101 and 102, and the like, for example.

According to the present embodiment, the intermediate portion 14 includes the fine particles 141 having the perovskite structure. Thus, protons generated from water molecules included in the atmosphere or the like around the power generation element 1 move to the electrode (the first electrode 11) on the low potential side due to the electric field between the electrodes (the first electrode 11 and the second electrode 12). Then, along with the movement of protons, movement of electrons between the electrodes is activated. This makes it possible to improve the power generation amount.

Additionally, according to the present embodiment, the intermediate portion 14 includes the non-conductive layer 142 containing the fine particles 141. That is, movement of the fine particles 141 between the electrodes is suppressed by the non-conductive layer 142. Thus, uneven distribution of the fine particles 141 on one electrode side over time and a decrease in movement amount of electrons can be prevented. This makes it possible to stabilize the power generation amount.

Additionally, according to the present embodiment, the intermediate portion 14 includes the non-conductive layer 142 supporting the first electrode 11 and the second electrode 12. Thus, as compared with the case where a solvent or the like is used instead of the non-conductive layer 142, a support portion or the like for maintaining the distance (gap G) between the electrodes does not need to be provided, and the variation in the gap G caused by formation accuracy of the support portion can be eliminated. This makes it possible to increase the power generation amount.

Further, according to the present embodiment, the non-conductive layer 142 includes a material having hydrophilicity. Thus, the state in which the water molecules are close to the fine particles 141 can be easily maintained. This makes it possible to further stabilize the power generation amount.

Further, according to the present embodiment, the non-conductive layer 142 includes an organic polymer compound. Thus, the non-conductive layer 142 can be flexibly formed. As a result, the power generation element 1 having a shape suitable for its application can be obtained.

Further, according to the present embodiment, for example, in the sealing material forming process S140, the sealing material 17 being in contact with the first electrode 11, the intermediate portion 14, and the second electrode 12 may be formed after the second electrode forming process S130. In this case, deterioration of the non-conductive layer 142 and the fine particles 141 caused by an external environment can be suppressed. This can improve durability.

Further, according to the present embodiment, for example, in the second electrode forming process S130, the second electrode 12 may be formed on the surface of the non-conductive layer 142 under a reduced pressure environment. In this case, the variation in the work function of the second electrode 12 can be suppressed. This makes it possible to further stabilize the power generation amount.

Further, according to the present embodiment, for example, the second electrode forming process S130 may include bringing the surface of the second electrode 12 provided on the second substrate 16 in advance into contact with the surface of the non-conductive layer 142. In this case, as compared with the case where the second electrode 12 is directly formed on the surface of the non-conductive layer 142, a variation in a surface state of the second electrode 12 caused by a surface state of the non-conductive layer 142 can be suppressed. This makes it possible to increase the power generation amount.

Further, according to the present embodiment, for example, the intermediate portion 14 may be provided on the first electrode 11 and may include the non-conductive layer 142 that is solid and the fine particles 141 fixed in a dispersed state in the non-conductive layer 142. That is, movement of the fine particles 141 between the electrodes (the first electrode 11 and the second electrode 12) is suppressed by the non-conductive layer 142. In this case, uneven distribution of the fine particles 141 on one electrode side over time and a decrease in movement amount of electrons can be suppressed. This makes it possible to stabilize the power generation amount.

Further, according to the present embodiment, for example, the intermediate portion 14 may be provided on the first electrode 11 and may include the non-conductive layer 142 that is solid. Furthermore, the second electrode 12 may be provided on the non-conductive layer 142 and may have a work function different from that of the first electrode 11. In this case, as compared with the case where a solvent or the like is used instead of the non-conductive layer 142, a support portion or the like for maintaining the distance (gap G) between the electrodes does not need to be provided, and the variation in the gap G caused by formation accuracy of the support portion or the like can be eliminated. This makes it possible to increase the power generation amount.

### Second Embodiment: Power Generation Element 1

Next, an example of the power generation element 1 according to a second embodiment will be described. A difference between the above-described embodiment and the present embodiment is that the intermediate portion 14 includes a locking portion 143. Note that description of similar contents to those of the above-described configuration will be omitted.

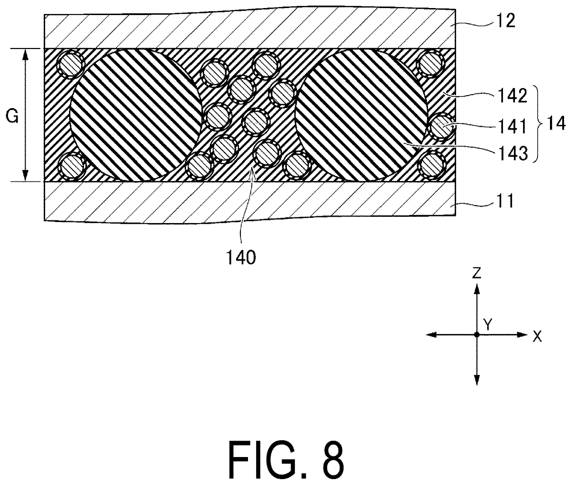

For example, as illustrated in FIG. 8, the intermediate portion 14 includes a plurality of locking portions 143 that support the first electrode 11 and the second electrode 12. The locking portion 143 may have, for example, a spherical shape, a cylindrical shape, or any other shape depending on the application.

An insulating material is used as the locking portion 143, and for example, a metal oxide is used. As the locking portion 143, for example, a material such as zirconia (ZrO₂), titania (TiO₂), silica (SiO₂), alumina (Al₂O₃), or iron oxide (Fe₂O₃, Fe₂O₅) is used.

The locking portion 143 has a size having a value equivalent to a value of the gap G described above, for example. The locking portion 143 has a size equivalent to the above-described thickness of the non-conductive layer 142, for example. The locking portion 143 has, for example, a spherical shape having a median diameter larger than that of the fine particle 141.

### Second Embodiment: Method for Manufacturing Power Generation Element 1

Next, an example of a method for manufacturing the power generation element 1 according to the second embodiment will be described. A difference between the above-described embodiment and the present embodiment is that the locking portions 143 are formed in the intermediate portion forming process S120. Note that description of similar contents to those of the above-described configuration will be omitted.

In the intermediate portion forming process S120 of the present embodiment, for example, a non-conductive material in which the fine particles 141 and the plurality of locking portions 143 are mixed is applied to the surface of the first electrode 11 and the like. In the intermediate portion forming process S120, for example, after the plurality of locking portions 143 are formed on the surface of the first electrode 11 or the like, the non-conductive material containing the fine particles 141 may be applied. By forming the locking portion 143, a width of the gap G can be easily controlled in forming the second electrode 12 on the non-conductive material before and after curing.

According to the present embodiment, the intermediate portion 14 includes the plurality of locking portions 143 supporting the first electrode 11 and the second electrode 12. This can suppress a variation in the gap caused by the non-conductive layer 142. This makes it possible to further increase the power generation amount.

Further, according to the present embodiment, the locking portion 143 has a spherical shape having a median diameter larger than that of the fine particle 141. Thus, a contact area between the locking portion 143 and each of the electrodes 11 and 12 can be minimized. Accordingly, a decrease in the power generation amount due to the arrangement of the locking portions 143 can be suppressed.

### Embodiment: Electronic Apparatus 500

### Electronic Apparatus 500

The power generation element 1 and the power generation device 100 that have been described above can be mounted on, for example, an electronic apparatus. Some embodiments of the electronic apparatus will be described below.

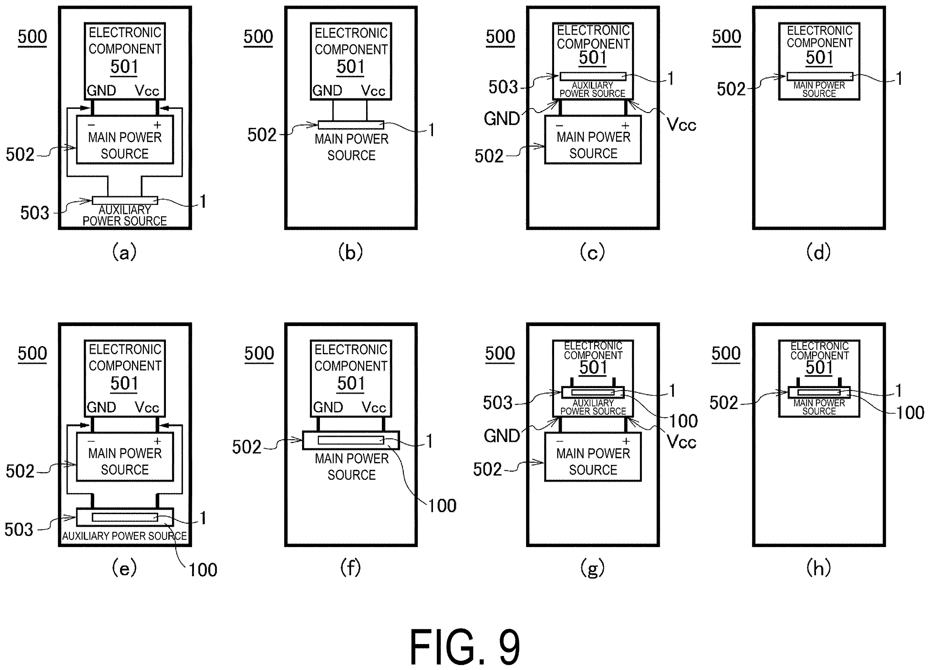

FIG. 9(a) to FIG. 9(d) are schematic block diagrams illustrating examples of an electronic apparatus 500 including the power generation element 1. FIG. 9(e) to FIG. 9(h) are schematic block diagrams illustrating examples of the electronic apparatus 500 including the power generation device 100 including the power generation element 1.

As illustrated in FIG. 9(a), the electronic apparatus 500 (electric product) includes an electronic component 501 (electronic component), a main power source 502, and an auxiliary power source 503. Each of the electronic apparatus 500 and the electronic component 501 is an electrical device.

The electronic component 501 is driven by using the main power source 502 as a power source. Examples of the electronic component 501 include a CPU, a motor, a sensor terminal, and a lighting device. When the electronic component 501 is, for example, the CPU, the electronic apparatus 500 includes an electronic device that can be controlled by a built-in master (CPU). When the electronic component 501 includes, for example, at least one of the motor, the sensor terminal, the lighting device, and the like, the electronic apparatus 500 includes an external master or an electronic apparatus that can be controlled by a person.

The main power source 502 is, for example, a battery. Examples of the battery also include rechargeable batteries. A positive terminal (+) of the main power source 502 is electrically connected to a Vcc terminal (Vcc) of the electronic component 501. A negative terminal (-) of the main power source 502 is electrically connected to a GND terminal (GND) of the electronic component 501.

An auxiliary power source 503 is the power generation element 1. The power generation element 1 includes at least one power generation element 1 described above. In the electronic apparatus 500, the auxiliary power source 503 is used together with the main power source 502, for example, and can be used as a power source for assisting the main power source 502 or as a power source for backing up the main power source 502 when a capacity of the main power source 502 is exhausted. When the main power source 502 is a rechargeable battery, the auxiliary power source 503 can also be used as a power source for charging the battery.

As illustrated in FIG. 9(b), the main power source 502 may be the power generation element 1. The electronic apparatus 500 illustrated in FIG. 9(b) includes the power generation element 1 to be used as the main power source 502 and the electronic component 501 capable of being driven by using the power generation element 1. The power generation element 1 is an independent power source (for example, an off-grid power source). Thus, the electronic apparatus 500 can be, for example, a stand-alone type. In addition, the power generation element 1 is an energy harvesting type. The electronic apparatus 500 illustrated in FIG. 9(b) does not need to replace the battery.

As illustrated in FIG. 9(c), the electronic component 501 may include the power generation element 1. An anode of the power generation element 1 is electrically connected to, for example, a GND wiring line of a circuit board (not illustrated). A cathode of the power generation element 1 is electrically connected to, for example, a Vcc wiring line of the circuit board (not illustrated). In this case, the power generation element 1 can be used as, for example, the auxiliary power source 503 of the electronic component 501.

As illustrated in FIG. 9(d), when the electronic component 501 includes the power generation element 1, the power generation element 1 can be used as, for example, the main power source 502 of the electronic component 501.

As illustrated in each of FIG. 9(e) to FIG. 9(h), the electronic apparatus 500 may include the power generation device 100. The power generation device 100 includes the power generation element 1 as a source of electric energy.

The embodiment illustrated in FIG. 9(d) includes the power generation element 1 in which the electronic component 501 is used as the main power source 502. Similarly, the embodiment illustrated in FIG. 9(h) includes the power generation device 100 in which the electronic component 501 is used as a main power source. In these embodiments, the electronic component 501 includes an independent power source. Thus, the electronic component 501 can be, for example, a self-standing type. The self-standing electronic component 501 can be effectively used in, for example, an electronic apparatus that includes a plurality of electronic components and in which at least one electronic component is separated from another electronic component. An example of such an electronic apparatus 500 is a sensor. The sensor includes a sensor terminal (slave) and a controller (master) separated from the sensor terminal. Each of the sensor terminal and the controller is the electronic component 501. When the sensor terminal includes the power generation element 1 or the power generation device 100, the sensor terminal is a self-standing type sensor terminal and does not need to be supplied with electric power by wiring. Since the power generation element 1 or the power generation device 100 is an energy harvesting type, the battery does not need to be replaced. The sensor terminal can also be regarded as one electronic apparatus 500. The sensor terminal regarded as the electronic apparatus 500 further includes, for example, an IoT wireless tag and the like in addition to the sensor terminal of the sensor.

What is common to the embodiments illustrated in FIG. 9(a) to FIG. 9(h) is that the electronic apparatus 500 includes the power generation element 1 that converts thermal energy into electric energy, and the electronic component 501 that can be driven by using the power generation element 1 as a power source.

The electronic apparatus 500 may be an autonomous type including an independent power source. Examples of the autonomous type of electronic apparatus include robots. Furthermore, the electronic component 501 including the power generation element 1 or the power generation device 100 may be an autonomous type including an independent power source. Examples of the autonomous type of electronic component include movable sensor terminals.

Although some embodiments have been described, these embodiments have been presented by way of examples only, and are not intended to limit the scope of the invention. Indeed, these novel embodiments described herein may be embodied in a variety of other forms, and furthermore, various omissions, substitutions and changes in the forms of the embodiments described herein may be made without departing from the spirit of the invention. These embodiments and modifications thereof are included in the scope and gist of the invention, and are included in the invention described in the claims and the scope equivalent thereto.

### Reference Signs List

1: Power generation element
11: First electrode
12: Second electrode
14: Intermediate portion
15: First substrate
16: Second substrate
17: Sealing material
100: Power generation device
101: First wiring line
102: Second wiring line
140: Space
141: Fine particle
141a: Coating
142: Non-conductive layer
142s: Solvent
143: Locking portion
500: Electronic apparatus
501: Electronic component
502: Main power source
503: Auxiliary power source
G: Gap
R: Load
S100: Element forming process
S110: First electrode forming process
S120: Intermediate portion forming process
S130: Second electrode forming process
S140: Sealing material forming process
Z: First direction
X: Second direction
Y: Third direction

## Claims

1. A power generation element that does not require a temperature difference between electrodes in converting thermal energy into electric energy, the power generation element comprising:
a first electrode;
an intermediate portion provided on the first electrode, the intermediate portion including a fine particle exhibiting a perovskite structure; and
a second electrode provided on the intermediate portion, the second electrode having a work function different from a work function of the first electrode.

2. The power generation element according to claim 1, wherein
the fine particle includes at least one of titanium and zirconium.

3. The power generation element according to claim 1 or 2, wherein
the fine particle includes at least one of barium titanate, strontium titanate, calcium titanate, lead titanate, tin titanate, cadmium titanate, and strontium zirconate.

4. The power generation element according to any one of claims 1 to 3, wherein
the intermediate portion includes a non-conductive layer including the fine particle, the non-conductive layer supporting the first electrode and the second electrode.

5. The power generation element according to claim 4, wherein
the non-conductive layer includes a material having hydrophilicity.

6. The power generation element according to claim 5, wherein
the non-conductive layer includes an organic polymer compound.

7. The power generation element according to any one of claims 4 to 6, wherein
the intermediate portion includes a plurality of locking portions supporting the first electrode and the second electrode.

8. The power generation element according to claim 7, wherein
the locking portion has a spherical shape having a median diameter larger than a median diameter of the fine particle.

9. A method for manufacturing a power generation element that does not require a temperature difference between electrodes in converting thermal energy into electric energy, the method comprising:
an element forming process of forming
a first electrode,
an intermediate portion including a fine particle exhibiting a perovskite structure, and
a second electrode having a work function different from a work function of the first electrode.

10. A power generation device comprising:
the power generation element according to claim 1;
a first wiring line electrically connected to the first electrode; and
a second wiring line electrically connected to the second electrode.

11. An electronic apparatus comprising:
the power generation element according to claim 1; and
an electronic component configured to be driven by using the power generation element as a power source.
